# EUROPEAN PATENT APPLICATION

(11) **EP 2 230 507 A1**
(43) Date of publication of application: **22.09.2010**
(21) Application number: 09250747.4
(22) Date of filing: 17.03.2009
(51) Int. Cl.: G01N 27/12, G01N 27/22

(54) **Humidity or gas sensor**

(71) Applicant: NXP B.V., 5656 AG Eindhoven (NL)
(72) Inventor: Merz, Matthias, Redhill, Surrey RH1 1DL (GB); Ponomarev, Youri, Redhill, Surrey RH1 1DL (GB); Curatola, Gilberto, Redhill, Surrey RH1 1DL (GB); Fotopoulou, Korina, Redhill, Surrey RH1 1DL (GB); Hoofman, Romano, Redhill, Surrey RH1 1DL (GB); Tombeur, Anton, Redhill, Surrey RH1 1DL (GB)
(74) Representative: Williamson, Paul Lewis

(57) **Abstract**

An environmental sensor (200) comprising: a semiconductor die (110) having a transducer (120) provided on a surface thereof; a carrier substrate (210) comprising electrical connections (230) connected to the semiconductor die surface; and a layer (250) of a sealing compound covering the semiconductor die surface and providing a seal between the die and the carrier substrate, wherein the transducer is configured to detect a change in an environmental parameter to which the sealing compound is exposed.

## Description

The invention relates to solid state sensor devices for measuring environmental parameters such as humidity and other gas concentrations.

Solid state sensors, in particular sensors based on semiconductor process technology, commonly comprise a sensor medium having a characteristic that depends on the environmental parameter to be measured. The sensor medium may be a particular material that exhibits a change in conductivity, for example, with a change in environmental condition such as a gas concentration. Typical environmental parameters include humidity (i.e. water vapour concentration) and concentrations of other gases such as CO₂, O₂ or H₂. A transducer part of such a sensor can be configured to convert a change in the environmental parameter into a corresponding characteristic change in an electrical parameter that can be converted into a measurable electrical signal. Further processing of the electrical signal can be applied to obtain an output electrical signal. As an example, co-pending European application 08105307.6 describes a capacitive humidity sensor, in which a layer of polymer or other dielectric material is used, the electrical properties of which (i.e. resistance or capacitance) depend on the humidity of the air the sensor is exposed to. The layer is deposited over a pair of interdigitated electrodes, which are configured to measure the impedance of the material between them. A change in impedance reflects a change in the air humidity level, which can then be processed to output a humidity reading in the form of an electrical signal.

Depending on the sensitivity of the material used as the sensor layer, sensors of this type can be realized to measure other environmental parameters such as gas concentrations in a similar way, for example concentrations of CO₂, hydrocarbons etc.

Deposition and patterning of the sensitive layer typically involves several processing steps, in addition to conventional device manufacturing. These processing steps typically include deposition of the sensor material over the transducer structure, followed by further packaging processes to protect the transducer and other sensitive sensor components.

It is an object of the invention to address the above identified issues, in order to provide a simplified sensor package.

In accordance with a first aspect of the invention there is provided an environmental sensor comprising:
a semiconductor die having a transducer provided on a surface thereof;
a carrier substrate comprising electrical connections connected to the semiconductor die surface; and
a layer of a sealing compound covering the semiconductor die surface and providing a seal between the die and the carrier substrate,
wherein the transducer is configured to detect a change in an environmental parameter to which the sealing compound is exposed.

The invention allows for a lower cost manufacturing route for a solid state sensor device through a reduction in the number of required processing steps, by using the sensor material itself as part of the sensor packaging. Process steps for depositing the sensitive layer and opening bond pads can thereby be omitted, reducing manufacturing costs. The invention is especially suited for high volume low cost sensor applications such as miniature sensors or in smart RFID (radiofrequency identification) tags used, for example, in supply chain monitoring.

The transducer of the sensor may comprise a pair of electrodes having a gap therebetween, over which the sealing compound is disposed.

The transducer may be configured to detect a change in the environmental parameter by a change in electrical resistance across the gap between the electrodes.

The transducer may alternatively be configured to detect a change in the environmental parameter by a change in capacitance across the gap between the electrodes.

The environmental parameter may be humidity, or a concentration of a gas.

A packaging compound may be disposed over the layer of sealing compound, a gap in the packaging compound provided over the transducer to allow exposure of the sealing compound to the environmental parameter to be measured.

The electrical connections between the semiconductor die and the carrier substrate may be provided on an opposing surface of the semiconductor die to the surface on which the sealing compound is provided. This configuration would apply to chips having bond wire connections to the carrier substrate.

The layer of sealing compound may alternatively be provided between the semiconductor die surface and a surface of the substrate to which the semiconductor die is attached. This alternative configuration would apply where the semiconductor die is 'flip-chip' bonded to the carrier substrate. In such a configuration, the substrate can advantageously comprise an aperture to allow exposure of the sealing compound to the environmental parameter to be measured.

In accordance with a second aspect of the invention there is provided a method of manufacturing an environmental sensor, the method comprising:
providing a semiconductor die having a transducer provided on a surface thereof;
attaching the semiconductor die to a carrier substrate, making electrical connections connecting the carrier substrate to the semiconductor die surface; and
applying a layer of a sealing compound covering the semiconductor die surface to provide a seal between the die and the carrier substrate,
wherein the transducer is configured to detect a change in an environmental parameter to which the sealing compound is exposed.

The step of applying the layer of sealing compound may be performed either before or after attaching the semiconductor die to the carrier substrate. In the case of a bond wire attachment configuration, the sealing compound would generally be applied after attachment, whereas for a flip-chip configuration the sealing compound may optionally be applied after attachment, for example via an aperture in the carrier substrate.

The sealing compound may be disposed between opposing surfaces of the semiconductor die and the carrier substrate, for example in a flip-chip configuration. In such a configuration, an aperture is preferably provided in the carrier substrate to allow exposure of the sealing compound to the environmental parameter to be measured.

A packaging compound may optionally be provided over the layer of sealing compound, a gap in the packaging compound being provided over the transducer to allow exposure of the sealing compound to the environmental parameter to be measured. This feature would be more applicable to the bond wire attached configuration of sensor, where the sealing compound may require further mechanical protection.

An important feature of the invention is to re-use part of the device package, or adhesive/glob top typically used for packaging, as a sensitive layer, thereby superseding extra steps for deposition and patterning. Conventional chips and process flows can be used, with little or no changes required at the fabrication plant, and the sensor capability is only added during packaging.

The invention will now be described by way of example and with reference to the accompanying drawings, in which:
figure 1a is a schematic plan view of a semiconductor die having interdigitated electrodes forming a transducer;
figure 1b is a schematic side view of the semiconductor die of figure 1 a;
figure 2a is a schematic side view of the sensor chip of figure 1 attached to a carrier substrate;
figure 2b is a schematic side view of the sensor of figure 2a with a sealing compound applied over the sensor chip;
figure 2c is a schematic side view of an alternative embodiment of the sensor of figure 2a, having a packaging material provided over the sealing compound;
figure 3a is a schematic side view of a sensor comprising a flip-chip die prior to attachment of the die to a carrier substrate;
figure 3b is a schematic side view of the sensor of figure 3a after attachment of the die to the carrier substrate; and
figure 3c is a schematic side view of the sensor of figure 3b after application of a sealing compound.

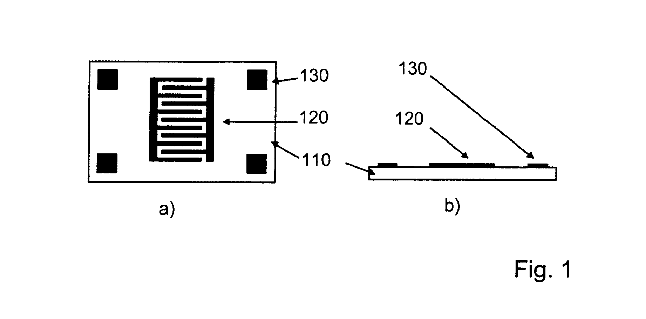

Illustrated in figure 1, in plan view (figure 1a) and side view (figure 1 b) is an example of a sensor chip 110, comprising a transducer structure 120 and four bond pads 130 for connection to an external circuit board. Other components for operating the sensor may also be integrated into the chip 110, for obtaining, amplifying and converting a signal from the transducer 120 into a readable output signal, which may be in digital or analog form. The sensor chip may be manufactured through a conventional CMOS process and may comprise AD or DA converters, signal processors, memory, an RF module etc.

The transducer 120 shown in figure 1 is in the form of a pair of interdigitated electrodes, which allows a long narrow electrode gap to be confined in a small area, increasing the sensitivity of the transducer.

The transducer 120 may be formed in the same metal layer as the bond pads, i.e. as part of the same lithographic process step. Alternative transducer structures to those illustrated may include meander forks, parallel metal lines and other arrangements comprising a pair of electrodes having a gap therebetween.

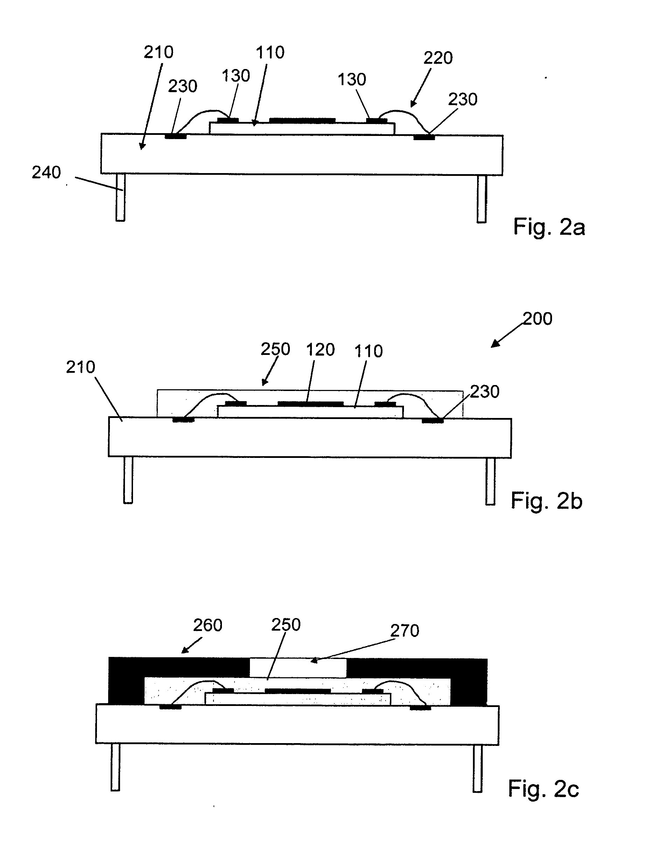

Figure 2a shows the sensor chip 110 in place on a carrier substrate 210. Bond wires 220 connect the bond pads 130 on the chip 110 to corresponding pads 230 on the carrier substrate 210. Contact pins 240 on the carrier substrate 210 allow the sensor package to be mounted on a circuit board. Other conventional means of mounting the sensor package may be used.

The sensor chip 110 is glued onto the carrier substrate 210 and wire bonded. Following this process, a 'glob top' layer 250, as shown in figure 2b, is deposited over the chip 110 to protect the wire bonds and semiconductor die. In the context of the present invention, however, the layer 250 also acts as the sensitive layer for the sensor, by covering the transducer 120 as well as serving to form a seal between the chip 110 and the carrier substrate 210. The material composition of this layer 250 is such that it has the desired environmental sensitivity (for example to humidity), while providing sufficient protection to the die and wire bonds.

Exemplary suitable materials for the sensitive layer 250 include polyimide, polyester, PMMA (polymethylmethacrylate), porous SiLK^{®} (a low k semiconductor dielectric resin) and nano-clustered silicate. The material used should be sensitive to changes in humidity as well as providing mechanical protection. For resistive type sensors, the resistivity of the sensor material should not be chosen to be too low otherwise short circuits may be made between bondpads of the underlying structure. The main parameters to consider are the material composition, which determines the sensitivity to humidity and the resistivity of the layer, and the thickness of the applied layer 250, which determines the response time of the sensor, the degree of protection of the underlying structure and the overall size of the package. For a short response time and high sensitivity, the layer 250 should be thin, yet above a minimum thickness needed for mechanical protection. A typical thickness of around 100µm-300µm would be suitable for a package with bond wires. A thinner layer of around 5µm -50µm may be suitable for flip-chip packages. Simulations have shown that sensor material layers thinner than this range can also work, reducing the possible lower limit of the above thickness range for flip-chip packages to 500nm. In general terms therefore, the thickness of the layer 250 may be between 0.5 µm and 300 µm.

The entire sensor device package 200 may be further encapsulated, for example with a moulded plastic package 260, as shown in figure 2c. An opening 270 in the package 260 allows direct contact between the environment (e.g. air) and the sensitive layer 250.

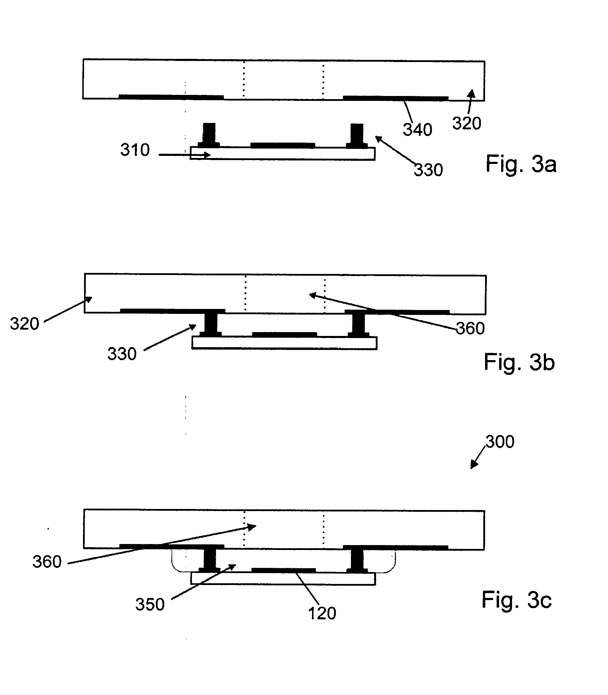

Figures 3a-c depict an alternative embodiment of a sensor package, employing a flip-chip configuration. The sensor chip 310 is bonded to the carrier substrate 320 by means of electrical contacts 330, e.g. in the form of pins or solder bumps, being attached to bond pads 340 on the carrier substrate 320. Sealing compound 350 (figure 3c) is then applied between the die 310 and the carrier substrate 320, the sealing compound 350 again acting as the sensitive layer for the transducer 120. An opening or aperture 360 may be provided in the carrier substrate 320 to increase the available surface area between the transducer 120 and the environment. Otherwise, the sensitive area is defined only by the small gap between the die 310 and the carrier substrate 360, which would result in a slower response time and lower sensitivity.

The sensitive layer 250, 350, is preferably deposited after contacts have been established between the sensor chip 110 with the carrier substrate 210, or while establishing contact between the chip 310 and the carrier substrate 320, e.g. by pressing the contacts 330 into the liquid sealing compound 350 before curing. No separate steps are therefore needed for removing the sensitive material from bond pads on the sensor chip or carrier substrate, which might otherwise be required in conventional sensor packaging.

Operation of the sensor device 200, 300 can be the same as for any other type of sensor manufactured by conventional processing. The impedance of the transducer 120 is affected by the sensitive material 250, 350, a change in environmental conditions (e.g. humidity) altering the properties of the sensitive layer and causing a change in resistance and/or capacitance, which is measured by the electronic circuits integrated on the die (or by external circuits).

Other embodiments are intentionally within the scope of the invention, as defined by the appended claims.

## Claims

1. An environmental sensor comprising:
a semiconductor die having a transducer provided on a surface thereof;
a carrier substrate comprising electrical connections connected to the semiconductor die surface; and
a layer of a sealing compound covering the semiconductor die surface and providing a seal between the die and the carrier substrate,
wherein the transducer is configured to detect a change in an environmental parameter to which the sealing compound is exposed.

2. The sensor of claim 1 wherein the transducer comprises a pair of electrodes having a gap therebetween over which the sealing compound is disposed.

3. The sensor of claim 2 wherein the transducer is configured to detect a change in the environmental parameter by a change in electrical resistance across the gap between the electrodes.

4. The sensor of claim 2 wherein the transducer is configured to detect a change in the environmental parameter by a change in capacitance across the gap between the electrodes.

5. The sensor of any preceding claim wherein the environmental parameter is humidity.

6. The sensor of any one of claims 1 to 4 wherein the environmental parameter is a concentration of a gas.

7. The sensor of any preceding claim wherein a packaging compound is disposed over the layer of sealing compound, a gap in the packaging compound provided over the transducer to allow exposure of the sealing compound to the environmental parameter to be measured.

8. The sensor of any preceding claim wherein the electrical connections between the semiconductor die and the carrier substrate are provided on an opposing surface of the semiconductor die to the surface on which the sealing compound is provided.

9. The sensor of any one of claims 1 to 6 wherein the layer of sealing compound is provided between the semiconductor die surface and a surface of the substrate to which the semiconductor die is attached.

10. The sensor of claim 9 wherein the substrate comprises an aperture to allow exposure of the sealing compound to the environmental parameter to be measured.

11. A method of manufacturing an environmental sensor, the method comprising:
providing a semiconductor die having a transducer provided on a surface thereof;
attaching the semiconductor die to a carrier substrate, making electrical connections connecting the carrier substrate to the semiconductor die surface; and
applying a layer of a sealing compound covering the semiconductor die surface to provide a seal between the die and the carrier substrate,
wherein the transducer is configured to detect a change in an environmental parameter to which the sealing compound is exposed.

12. The method of claim 11 wherein the step of applying the layer of sealing compound is performed after attaching the semiconductor die to the carrier substrate.

13. The method of claim 11 or claim 12 wherein the sealing compound is disposed between opposing surfaces of the semiconductor die and the carrier substrate.

14. The method of claim 13 wherein an aperture is provided in the carrier substrate to allow exposure of the sealing compound to the environmental parameter to be measured.

15. The method of claim 11 further comprising applying a packaging compound over the layer of sealing compound, a gap in the packaging compound being provided over the transducer to allow exposure of the sealing compound to the environmental parameter to be measured.
